Europäisches Patentamt

European Patent Office

Office européen des brevets

(19)

(11) EP 0 633 664 B1

(12) **FASCICULE DE BREVET EUROPEEN**

(45) Date de publication et mention
de la délivrance du brevet:
**19.11.1997 Bulletin 1997/47**

(51) Int Cl.⁶: **H03K 19/00**, H03K 3/356,
H02M 3/07

(21) Numéro de dépôt: **94201858.1**

(22) Date de dépôt: **28.06.1994**

(54) **Circuit d'interface et circuit élévateur de tension comportant un tel circuit**

**Schnittstellenschaltung und diese Schaltung enthaltende Spannungserhöhungsschaltung**

Interface circuit and voltage booster circuit including such circuit

(84) Etats contractants désignés:
**DE FR SE**

(30) Priorité: **30.06.1993 FR 9308004**

(43) Date de publication de la demande:
**11.01.1995 Bulletin 1995/02**

(73) Titulaires:
• **PHILIPS COMPOSANTS ET
SEMICONDUCTEURS
92150 Suresnes (FR)**
Etats contractants désignés:
**FR**
• **PHILIPS ELECTRONICS N.V.
5621 BA Eindhoven (NL)**
Etats contractants désignés:
**DE SE**

(72) Inventeurs:
• **Boiron, Marc, Société Civile S.P.I.D.
F-75008 Paris (FR)**
• **Bouvier, Stéphane, Société Civile S.P.I.D.
F-75008 Paris (FR)**

(74) Mandataire: **Charpail, François et al
Société Civile S.P.I.D.
156, Boulevard Haussmann
75008 Paris (FR)**

(56) Documents cités:
EP-A- 0 342 581          US-A- 5 136 190
US-A- 5 191 233

## Description

La présente invention a pour objet un circuit d'interface qui permet, à partir d'un signal appliqué sur son entrée variant entre un niveau de référence disponible sur une première borne et un premier niveau de tension, de délivrer un signal de sortie variant entre ce niveau de référence et un second niveau de tension tel que l'excursion du signal de sortie soit supérieure ou égale à celle du signal d'entrée, ce second niveau de tension étant disponible sur une seconde borne, et qui comporte:

- une première et une seconde branches comprenant chacune un premier et un second transistors complémentaires l'un de l'autre, qui disposent d'une première et d'une seconde électrodes principales et d'une électrode de commande, et dont les trajets première électrode principale-seconde électrode principale et seconde électrode principale-première électrode principale sont mis en série entre lesdites bornes, les électrodes de commande des premiers transistors de la première et de la seconde branches étant respectivement reliées aux secondes électrodes principales des premiers transistors de la seconde et de la première branche,
- et un premier module inverseur dont l'entrée est directement connectée à l'entrée du circuit d'interface ainsi qu'à l'électrode de commande du second transistor de la première branche, et dont la sortie est connectée à l'électrode de commande du second transistor de la seconde branche, et une troisième branche comprenant un premier et un second transistors complémentaires l'un de l'autre, dont les trajets première électrode principale-seconde électrode principale et seconde électrode principale-première électrode principale sont mis en série entre lesdites bornes, la seconde électrode principale du premier transistor de cette troisième branche constituant une sortie du circuit d'interface, et son électrode de commande étant connectée à celle du premier transistor de la seconde branche. US-A 5 191 233 décrit un tel circuit d'interface.

De tels circuits d'interface sont notamment utilisés dans des circuits élévateurs de tension permettant d'interfacer des circuits à basse tension d'alimentation et des circuits à plus forte tension d'alimentation. C'est par exemple le cas des circuits d'interfaçage de lecteur de cartes à puce portables qui sont soumis à de basses tensions d'alimentation (2,5V) alors que les cartes à puce nécessitent des tensions d'alimentation de 5V.

Un circuit d'interface de charge d'un condensateur utilisé dans un circuit élévateur de tension est décrit dans la demande de brevet européen n°0 342 581. En régime transitoire, lorsque le signal d'entrée du circuit d'interface passe du niveau haut au niveau bas par exemple, le premier et le second transistors de cette seconde branche sont tous les deux actifs pendant un court instant. Ce bref court-circuit crée un pic de courant d'autant plus élevé que les deux transistors sont largement dimensionnés.

Dans le cas d'applications à fort courant, et notamment pour les circuits d'interfaçage de lecteur de cartes à puce qui doivent supporter des pointes de courant de l'ordre de 20 mA, ces transistors doivent être largement dimensionnés, ce qui entraîne donc une chute notable du rendement total de l'élévateur de tension.

L'invention a pour but de proposer un circuit d'interface à fort courant, de faible encombrement, qui remédie à cet inconvénient.

Pour cela un circuit d'interface selon l'invention et tel que décrit dans le paragraphe introductif est caractérisé en ce que le premier et le second transistors de la troisième branche sont largement dimensionés par rapport à ceux de la seconde branche et en ce qu'il comporte

- un second module inverseur dont l'entrée est connectée à l'entrée du circuit d'interface et dont la sortie est connectée à l'électrode de commande du second transistor de cette troisième branche, les temps de réponse des premier et second modules inverseurs étant choisis de telle sorte que les premier et second transistors de la troisième branche ne soient jamais actifs au même instant.

Les premier et second transistors de la troisième branche du circuit d'interface n'étant jamais actifs au même instant, il est possible de les dimensionner largement sans baisser notablement le rendement du circuit. Les premier et second transistors de la seconde branche pouvant alors être dimensionnés plus faiblement, leur mise en court-circuit ne crée que de faibles pics de courant.

L'invention concerne également un circuit élévateur de tension comportant un circuit d'interface tel que décrit dans les paragraphes précédents, et en particulier, un circuit élévateur de tension qui comporte un circuit d'interface de commande de l'électrode de commande d'un transistor, de même polarité que les dits premiers transistors, constituant un interrupteur, les première et seconde électrodes principales de ce transistor étant respectivement connectées d'une part à une troisième borne délivrant un signal variant entre les premier et second niveaux de tension, et d'autre part à la seconde borne.

D'autres particularités, détails et avantages de l'invention seront mis en évidence par la description qui va suivre en regard des dessins annexés qui sont relatifs à des exemples donnés à titre non limitatif, dans lesquels :

- la figure 1 est un schéma d'un circuit d'interface selon l'art antérieur,
- la figure 2 est un schéma d'un exemple de circuit d'interface selon l'invention,
- la figure 3 est un schéma d'un module inverseur réalisé en technologie CMOS,
- la figure 4 est un schéma de principe d'un exemple de circuit élévateur de tension comportant un circuit d'interface selon l'invention.

Dans la description qui va suivre, les premiers transistors sont des MOSFET à canal P et les seconds sont des MOSFET à canal N. Les termes première et seconde électrodes principales et électrode de commande désignent donc respectivement la source, le drain et la grille de ces transistors. Sur les figures annexées, les transistors à canal P sont désignés par la lettre P suivie du numéro de référence du transistor. De même les transistors à canal N sont désignés par la lettre N suivie du numéro de référence du transistor.

Toutefois, et bien que ce mode de réalisation ne soit pas décrit, un circuit d'interface selon l'invention est réalisable avec des premiers transistors à canal N et des seconds transistors à canal P.

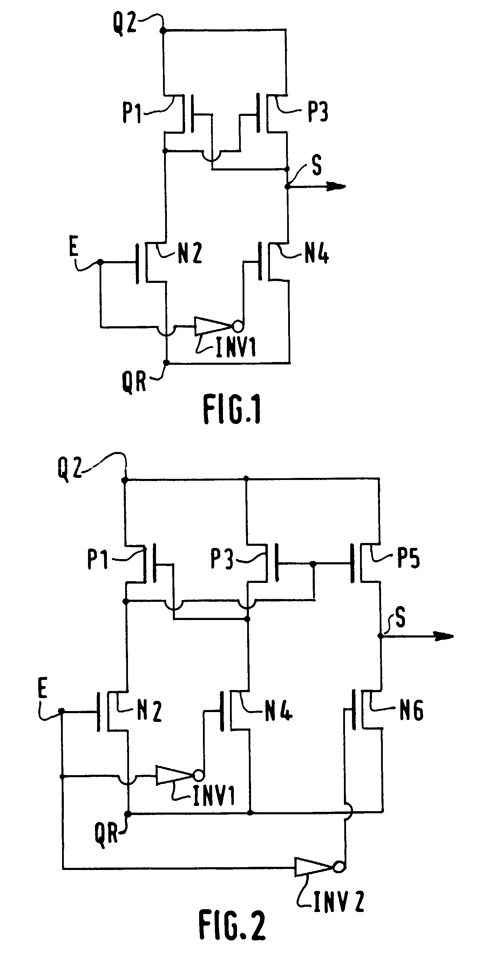

D'après la figure 1, un circuit d'interface selon l'art antérieur comprend deux branches comportant chacune un transistor MOS à canal P, P1 et P3, et un transitor MOS à canal N, N2 et N4. Les sources des transistors P1 et P3 sont reliées à une borne Q2 délivrant une tension V2, et leurs drains sont respectivement reliés aux drains des transistors N2 et N4. Les sources des transistors N2 et N4 sont reliées à une borne QR délivrant une tension de référence VR, et leurs grilles sont connectées à une borne E délivrant un signal d'entrée, directement pour le transistor N2, et par l'intermédiaire d'un module inverseur INV1 pour le transistor N4. La grille du transistor P3 est reliée au drain du transistor P1, et la grille du transistor P1 est reliée au drain du transistor P3, constituant ainsi une sortie S du circuit d'interface.

Durant le premier état stable (lorsque le niveau du signal d'entrée est égal à V1 par exemple), le transistor N4 est bloqué et le transistor N2 conduit, ce qui impose un niveau proche de VR sur la grille du transistor P3 qui, par conséquent, conduit également. Le niveau du signal de sortie en S est donc pratiquement égal à V2 et le transistor P1 est bloqué. Pendant l'état transitoire qui résulte du passage du signal d'entrée du niveau de tension V1 au niveau de référence VR, les transistors P3 et N4 conduisent tous les deux. Ce bref court-circuit crée un pic de courant I puisé sur la sortie S du circuit :

$$I = V2 / (R_{dsP3} + R_{dsN4})$$

où $R_{dsP3}$ et $R_{dsN4}$ sont les valeurs des résistances drain-source des transistors P3 et N4 en conduction. Elles sont égales à :

$$R_{ds} = [L / (W.\mu.C_0)] \cdot [V_{gs} - V_S]^{-1}$$

où

    L est la longueur du canal,
    W sa largeur,
    $\mu$ la mobilité des porteurs,
    $C_0$ la capacité grille-substrat du transistor par unité de surface
    $V_{gs}$ sa tension grille-source,
    et $V_S$ sa tension seuil.

Ce pic de courant est donc d'autant plus important que les valeurs de ces résistances sont faibles, c'est-à-dire que les transistors P3 et N4 sont largement dimensionnés.

Pour certaines applications à fort courant, les transistors P3 et N4 doivent être largement dimensionnés. L'utilisation d'un tel circuit d'interface conduit alors à une dégradation du rendement global.

La figure 2 est un exemple de circuit d'interface selon l'invention qui, tout en restant de faible encombrement, permet d'améliorer le rendement obtenu pour des applications à fort courant.

D'après la figure 2, un circuit d'interface selon l'invention comporte, en plus des éléments décrits sur la figure 1, une troisième branche comprenant un transistor MOS à canal P, P5, et un transistor MOS à canal M, N6. La source du transistor P5 est connectée à la borne Q2, sa grille est connectée à celle du transistor P3 et son drain est connecté à celui du transistor N6. La source du transistor N6 est connectée à la borne QR, et sa grille est reliée par l'intermédiaire d'un module inverseur INV2 à la borne d'entrée E. La sortie de ce circuit est désormais constituée par les drains des transistors P5 et N6.

Les modules inverseurs INV1 et INV2 sont construits de telle sorte que les transistors P5 et N6 ne soient jamais actifs au même instant. Ainsi, leurs larges dimensions n'ont pas d'influence sur le rendement global puisqu'aucun pic de courant ne se produit dans la troisième branche du circuit.

Lors d'une baisse du signal d'entrée du niveau de tension V1 au niveau de référence VR, les transistors N2 et P5 passent de l'état actif à l'état bloqué tandis que les transistors N4 et P6 passent de l'état bloqué à l'état actif. Pour que les transistors P5 et N6 ne soient pas actifs en même temps, il faut que le transistor N6 ne passe à l'état actif que lorsque le transistor P5 n'y est plus. C'est-à-dire que le module inverseur INV1 doit être plus rapide que le module inverseur INV2 pour une baisse du signal d'entrée. Au contraire pour une montée du signal d'entrée du niveau de référence VR au niveau de tension V1, le transistor P5 ne doit passer à l'état actif que lorsque le transistor N6 n'y est plus. C'est-à-dire que le module inverseur INV2 doit être plus rapide que le module inverseur INV1 pour une montée du signal d'entrée.

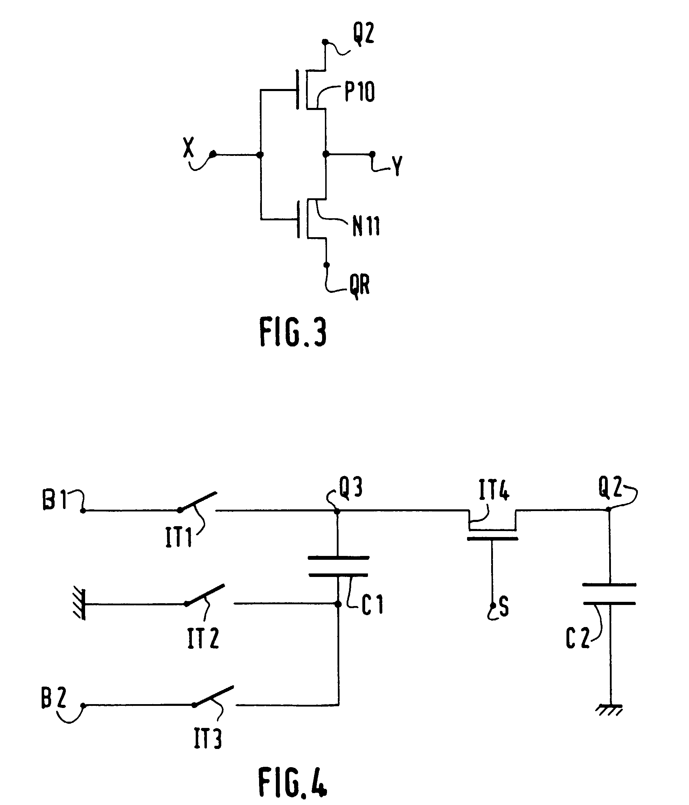

Pour cela, d'après la figure 3, chaque module inverseur est réalisé en technologie CMOS au moyen de deux transistors complémentaires l'un de l'autre P10 et N11, dont les drains sont réunis pour constituer la Y sortie du module inverseur, dont les grilles sont connectées à l'entrée X du module inverseur, la source du transistor P10 étant connectée à la borne Q2 et celle du transistor N11 à la borne QR. Et chaque transistor est dimensionné afin d'obtenir les temps de réponse indiqués dans le paragraphe précédent.

La figure 4 est un schéma de principe d'un exemple de circuit élévateur de tension comportant un circuit d'interface selon l'invention. Ce circuit comporte quatre interrupteurs IT1, IT2, IT3 et IT4 ainsi que deux capacités C1 et C2. La première borne de la capacité C1 est reliée d'une part à un noeud B1 par l'intermédiaire de l'interrupteur IT3, et d'autre part à la masse par l'intermédiaire de l'interrupteur IT2. Sa seconde borne Q3 est reliée d'une part à un noeud B2 par l'intermédiaire de l'interrupteur IT1, et d'autre part à la borne Q2 par l'intermédiaire de l'interrupteur IT4 réalisé à l'aide d'un transistor MOS à canal P. La grille du transistor IT4 est reliée à la sortie S d'un circuit d'interface tel que représenté sur la figure 2, et dont la borne QR est connectée à la masse. La borne Q2 enfin, est reliée à la masse par l'intermédiaire de la capacité C2.

Ce circuit élévateur de tension permet par exemple, à partir d'une tension V1 disponible sur les noeuds B1 et B2 d'obtenir une tension V2 égale à 2xV1 sur la borne Q2. Pour cela, dans un premier temps, la capacité C1 est chargée sous la tension V1 en fermant les interrupteurs IT1 et IT2. Puis, dans un deuxième temps, ce sont les interrupteurs IT3 et IT4 qui sont fermés de façon à référencer la capacité C1 à la tension V1 afin de charger la capacité C2 sous la tension 2xV1. Lorsque la tension V2=2xV1 est disponible sur la borne Q3, le transistor IT4 doit être actif de façon à charger la capacité C2. Sa grille doit donc recevoir un signal de niveau bas par rapport à V2. Ce signal lui est fourni par le circuit d'interface de la figure 2 sur l'entrée duquel un signal de tension VR est appliqué. Au contraire, pour fermer l'interrupteur IT4, on applique à la grille du transistor IT4 un signal de tension V2 qui lui est fourni par le circuit d'interface sur lequel un signal de niveau V1 est appliqué.

Dans le cas des circuits d'interfaçage de lecteur de cartes à puce par exemple, la capacité C2 doit supporter des décharges à fort courant. L'interrupteur IT4 est donc largement dimensionné, et sa capacité grille-substrat est importante. Cela implique que les deux transistors P5 et N6 de la troisième branche soient eux aussi largement dimensionnés.

Dans un exemple pratique de mise en oeuvre d'un tel circuit élévateur de tension pour circuit d'interfaçage de lecteur de cartes à puce, pour une fréquence du signal d'entrée égale à 2MHz, les rapports largeur de canal/longueur de canal (W/L) utilisés sont les suivants :

- transistor P1 : W/L = 100/2
- transistor N2 : W/L = 100/2
- transistor P3 : W/L = 30/2

- transistor N4 : W/L = 20/2
- transistor P5 : W/L = 1500/2
- transistor N6 : W/L = 1000/2
- transistor IT4 : W/L = 10000/2
- inverseur INV1 → transistor P10 : W/L = 30/2
  → transistor N11 : W/L = 6/2
- inverseur INV2 → transistor P10 : W/L = 30/2
  → transistor N11 : W/L = 50/2

Dans ces conditions, le circuit d'interface tel que représenté sur la figure 2 ne consomme que quelques centaines de micro-ampères en régime transitoire, alors que le circuit d'interface selon l'art antérieur consommait plusieurs centaines de milli-ampères. Il est ainsi possible d'augmenter le rendement d'un circuit élévateur de tension décrit sur la figure 4 de 72% à 85%.

Il va de soi que des variantes peuvent être apportées aux modes de réalisation qui viennent d'être décrits, notamment par substitution de moyens techniques équivalents, sans que l'on sorte pour cela du cadre de la présente invention tel que défini par les revendications suivantes.

**Revendications**

1. Circuit d'interface qui permet, à partir d'un signal appliqué sur son entrée (E) variant entre un niveau de référence (VR) disponible sur une première borne (QR) et un premier niveau de tension (V1), de délivrer un signal de sortie variant entre ce niveau de référence (VR) et un second niveau de tension (V2) tel que l'excursion du signal de sortie soit supérieure ou égale à celle du signal d'entrée, ce second niveau de tension (V2) étant disponible sur une seconde borne (Q2), et qui comporte:

- une première et une seconde branches comprenant chacune un premier (P1, P3) et un second (N2, N4) transistors complémentaires l'un de l'autre, qui disposent d'une première et d'une seconde électrodes principales et d'une électrode de commande, et dont les trajets première électrode principale-seconde électrode principale et seconde électrode principale-première électrode principale sont mis en série entre lesdites bornes (Q2, QR), les électrodes de commande des premiers transistors de la première et de la seconde branches (P1, P3) étant respectivement reliées aux secondes électrodes principales des premiers transistors de la seconde et de la première branche (P3, P1),
- un premier module inverseur (INV1) dont l'entrée est directement connectée à l'entrée (E) du circuit d'interface ainsi qu'à l'électrode de commande du second transistor de la première branche (N2), et dont la sortie est connectée à l'électrode de commande du second transistor de la seconde branche (N4), et

caractérisé en ce que le premier (P5) et le second (N6) transistors de la troisième branche sont largement dimensionnés par rapport à ceux de la seconde branche (P3, N4) et en ce qu'il comporte

- une troisième branche comprenant un premier (P5) et un second (N6) transistors complémentaires l'un de l'autre, dont les trajets première électrode principale-seconde électrode principale et seconde électrode principale-première électrode principale sont mis en série entre lesdites bornes (Q2, QR), la seconde électrode principale du premier transistor de cette troisième branche (P5) constituant une sortie (S) du circuit d'interface, et son électrode de commande étant connectée à celle du premier transistor de la seconde branche (P3),
- un second module inverseur (INV2) dont l'entrée est connectée à l'entrée (E) du circuit d'interface et dont la sortie est connectée à l'électrode de commande du second transistor de cette troisième branche (N6), les temps de réponse des premier et second modules inverseurs (INV1, INV2) étant choisis de telle sorte que les premier et second transistors (P5, N6) de la troisième branche ne soient jamais actifs au même instant.

2. Circuit d'interface selon la revendication 1, caractérisé en ce que ses transistors (P1, P3, P5, N2, N4, N6) sont des transistors à effet de champ MOS.

3. Circuit d'interface selon l'une des revendications 1 ou 2, caractérisé en ce que chaque module inverseur (INV1, INV2) comporte deux transistors complémentaires l'un de l'autre, qui sont dimensionnés de telle sorte que la réponse du premier module inverseur (INV1) soit d'une part plus rapide que celle du second (INV2) lorsque le signal disponible sur l'entrée (E) du circuit d'interface passe du premier niveau de tension (V1) au niveau de référence (VR), et d'autre part plus lente lorsque ce même signal passe du niveau de référence (VR) au premier niveau de tension (V1).

4. Circuit élévateur de tension, caractérisé en ce qu'il comporte au moins un circuit d'interface selon l'une des revendications 1 à 3.

5. Circuit élévateur de tension selon la revendication 4, caractérisé en ce qu'il comporte un circuit d'interface de commande de l'électrode de commande d'un transistor (IT4), de même polarité que les dits premiers transistors, constituant un interrupteur, les première et seconde électrodes principales de ce transistor (IT4) étant respectivement connectées d'une part à une troisième borne (Q3) délivrant un signal variant entre les premier et second niveaux de tension (V1, V2), et d'autre part à la seconde borne (Q2).

**Patentansprüche**

1. Schnittstellenschaltung, die es ermöglicht, ausgehend von einem Signal, das dem Eingang (E) zugeführt wird und zwischen einem Bezugspegel (VR) an einem ersten Anschluß (QR) und einem ersten Spannungspegel (V1) schwankt, ein Ausgangssignal zu liefern, das zwischen diesem Bezugspegel (VR) und einem zweiten Spannungspegel (V2) derart schwankt, daß der Verlauf des Ausgangssignals größer ist als der des Eingangssignals oder diesem entspricht, wobei dieser zweite Spannungspegel (V2) an einem zweiten Anschluß (Q2) verfügbar ist und wobei diese Schaltungsanordnung die nachfolgenden Elemente aufweist:

- einen ersten und einen zweiten Zweig, die je einen ersten (P1, P3) und einen zweiten (N2, N4) zueinander komplementären Transistor aufweisen, die je eine erste und eine zweite Hauptelektrode und eine Steuerelektrode aufweisen, und deren erste Hauptelektrode- / zweite Hauptelektrodenstrecke und zweite Hauptelektrode- / erste Hauptelektrodenstrecke in Reihe zwischen den genannten Anschlüssen (Q2, QR) vorgesehen sind, wobei die Steuerelektroden des ersten Transistors des ersten und des zweiten Zweiges (P1, P3) mit den zweiten Hauptelektroden des ersten Transistors des zweiten bzw. des ersten Zweiges (P3, P1) verbunden sind,
- ein erstes Invertermodul (INV1), dessen Eingang unmittelbar mit dem Eingang (E) der Schnittstellenschaltung sowie mit der Steuerelektrode des zweiten Transistors des ersten Zweiges (N2) verbunden ist und dessen Ausgang mit der Steuerelektrode des zweiten Transistors des zweiten Zweiges (N4) verbunden ist und
- einen dritten Zweig mit einem ersten (P5) und einem zweiten (N6) zueinander komplementären Transistor, wobei die erste Hauptelektrode-/ zweite Hauptelektrodenstrecke und die zweite Hauptelektrode-/ erste Hauptelektrodenstrecke in Reihe zwischen den genannten Anschlüssen (Q2, QR) vorgesehen sind, wobei die zweite Hauptelektrode des ersten Transistors dieses dritten Zweiges (P5) einen Ausgang (S) der Schnittstellenschaltung bildet, und wobei die Steuerelektrode mit der des ersten Transistors des zweiten Zweiges (P3) verbunden ist,

dadurch gekennzeichnet, daß der erste (P5) und der zweite (N6) Transistor des dritten Zweiges gegenüber denen des zweiten Zweiges (P3, N4) groß bemessen sind, und daß sie weiterhin

- ein zweites Invertermodul (INV2) enthält, dessen Eingang mit dem Eingang (E) der Schnittstellenschaltung verbunden ist und dessen Ausgang mit der Steuerelektrode des zweiten Transistors dieses dritten Zweiges (N6) verbunden ist, wobei die Responszeit des ersten und des zweiten Invertermoduls (INV1, INV2) derart gewählt worden ist, daß der erste und der zweite Transistor (P5, N6) des dritten Zweiges niemals gleichzeitig leitend sind.

2. Schnittstellenschaltung nach Anspruch 1, dadurch gekennzeichnet, daß die Transistoren (P1, P3, P5, N2, N4, N6) MOS-FETen sind.

3. Schnittstellenschaltung nach einem der Ansprüche 1 oder 2, dadurch gekennzeichnet, daß jedes Invertermodul (INV1, INV2) zwei zueinander komplementäre Transistoren aufweist, die derart bemessen sind, daß die responszeit des ersten Invertermoduls (INV1) einerseits schneller ist als die des zweiten (INV2), wenn das am dem Eingang (E) verfügbare Signal der Schnittstellenschaltung von dem ersten Spannungspegel (V1) zu dem bezugspegel (VR) ändert und andererseits langsamer, wenn dieses Signal von dem Bezugspegel (VR) zu dem ersten Spannungspegel (V1) ändert.

4. Spannungserhöhungsschaltung, dadurch gekennzeichnet, daß diese Schaltungsanordnung wenigstens eine Schnittstellenschaltung nach einem der Ansprüche 1 bis 3 enthält.

5. Spannungserhöhungsschaltung nach Anspruch 4, dadurch gekennzeichnet, daß diese Schaltungsanordnung eine Schnittstellenschaltung aufweist zum Steuern der Steuerelektroden eines Transistors (IT4) derselben Polarität wie die des ersten Transistors, dabei einen Unterbrechungsschalter bildend, wobei die erste und die zweite Hauptelektrode dieses Transistors (IT4) einerseits mit einem dritten Anschluß (Q3), der ein Signal liefert, das zwischen dem ersten und dem zweiten Spanungspegel (V1, V2) schwankt und andererseits mit dem zweiten Anschluß (Q2) verbunden ist.

**Claims**

1. An interface circuit supplying an output signal, on the basis of a signal applied to its input (E) varying between a reference level (VR) available at a first terminal (QR) and a first voltage level (V1), which output signal varies between said reference level (VR) and a second voltage level (V2) such that the variation in the output signal is greater than or equal to that of the input signal, said second voltage level (V2) being available at a second terminal (Q2), and which circuit comprises:

- a first and a second branch, each comprising a first (P1, P3) and a second (N2, N4) transistor which are mutually complementary and which each have a first and a second main electrode and a control electrode, while the paths between the first main electrode and the second main electrode and between the second main electrode and the first main electrode are connected in series between said terminals (Q2, QR), the control electrodes of the first transistors of the first and the second branch (P1, P3) being connected to the second main electrodes of the first transistors of the second and the first branch (P3, P1), respectively,
- a first inverter module (INV1) whose input is directly connected to the input (E) of the interface circuit as well as to the control electrode of the second transistor of the first branch (N2), and whose output is connected to the control electrode of the second transistor of the second branch (N4), and
- a third branch comprising a first (P5) and a second (N6) transistor which are mutually complementary and of which the paths between the first main electrode and the second main electrode and between the second main electrode and the first main electrode are connected in series between said terminals (Q2, QR), the second main electrode of the first transistor in this third branch (P5) forming an output (S) of the interface circuit, while its control electrode is connected to that of the first transistor of the second branch (P3),

characterized in that the first (P5) and the second (N6) transistor of the third branch are of large dimensions compared with those of the second branch (P3, N4), and in that it comprises a second inverter module (INV2) whose input is connected to the input (E) of the interface circuit and whose output is connected to the control electrode of the second transistor of said third branch (N6), the response times of the first and second inverter modules (INV1, INV2) being chosen such that the first and the second transistor (P5, N6) of the third branch are never active simultaneously.

2. An interface circuit as claimed in claim 1, characterized in that the transistors thereof (P1, P3, P5, N2, N4, N6) are MOS field effect transistors.

3.  An interface circuit as claimed in one of the claims 1 and 2, characterized in that each inverter module (INV1, INV2) comprises two mutually complementary transistors which are dimensioned such that the response of the first inverter module (INV1) is on the one hand faster than that of the second (INV2) when the signal available at the input (E) of the interface circuit passes from the first voltage level (V1) to the reference level (VR), and on the other hand slower when this same signal passes from the reference level (VR) to the first voltage level (V1).

4.  A voltage booster circuit, characterized in that it comprises at least an interface circuit as claimed in any one of the claims 1 to 3.

5.  A voltage booster circuit as claimed in claim 4, characterized in that it comprises an interface circuit for controlling the control electrode of a transistor (IT4) of the same polarity as said first transistors and forming a switch, the first and the second main electrode of this transistor (IT4) being connected to a third terminal (Q3) which delivers a signal varying between the first and the second voltage level (V1, V2), and to the second terminal (Q2), respectively.

FIG.1

FIG.2

FIG.3

FIG.4